# EUROPEAN PATENT APPLICATION

(11) **EP 3 263 748 A2**
(43) Date of publication of application: **03.01.2018**
(21) Application number: 17170300.2
(22) Date of filing: 09.05.2017
(51) Int. Cl.: C30B 25/10, C23C 16/46, C23C 16/54, C23C 16/458, F27B 9/06, F27B 9/36, F27D 11/02, F27D 11/06, H01L 21/67

(54) **CVD REACTOR WITH A MULTI-ZONE HEATED PROCESS CHAMBER**

(30) Priority: 12.05.2016 SE 1650640
(71) Applicant: Epiluvac AB, 223 70 Lund (SE)
(72) Inventor: Spengler, Richard, 22240 Lund (SE); Nilsson, Roger, 226 52 Lund (SE); Rosberg, Jonas, 224 60 Lund (SE)
(74) Representative: KIPA AB

(57) **Abstract**

A device, system and method for depositing crystalline layers on at least one crystalline substrate is described. The disclosure includes the use of a multi zone heater, the multi zone heater is disposed between a reactor housing and a process chamber. The multi zone heater has different electrical properties along its length, whereby the multi zone heater when heated by eddy currents induced by an RF field generated by a RF heating coil provides a temperature profile inside the multi zone heater that varies along the length of the multi zone heater for heating the process chamber.

## Description

### BACKGROUND OF THE INVENTION

### Field of the Invention

The disclosure relates to a device for depositing layers, in particular crystalline layers, on at least one substrate, in particular a crystalline substrate. The device comprises a process chamber formed by a wall element or a number of wall elements. The device comprises an RF heating coil surrounding a multi zone heating tube or shielding for heating the process chamber.

### Description of the Prior Art

DE 10055182 A1 discloses a device comprising a quartz tube within which a process chamber (also called susceptor) is located. The process chamber wall comprises a number of graphite elements that is a top, two walls and a bottom. The individual graphite wall elements engage against one another in touching contact. The known device is surrounded by an RF coil, which generates an RF field inside the reactor housing. The field produces eddy currents in the process chamber walls.
As a result of the contact resistances in the regions where the individual wall elements engage against one another, instances of local heating or even spark discharges occur.

US 8,062,426 B2 describes a device provided with a shield/heating tube disposed inside the reactor quartz tube but outside the process chamber, and be electrically conductive in such a manner that the RF field generated by the RF coil produces eddy currents there. These eddy currents are intended to heat the shielding/heating tube and at the same time dampen the field strength of the RF field in such a way that there is induced in the electrically conductive walls of the process chamber only a fraction of the eddy currents that apply in earlier prior art, so that the heating takes place substantially in the material of the shielding/heating tube. This has the consequence that the instances of local heating observed in the earlier prior art in the region of the contact zones of the individual process chamber wall elements are prevented. As a consequence of this, a homogenized temperature profile is obtained inside the process chamber of the hot-wall reactor. The shielding/heating tube consists of graphite. It comprises a single part and is solid. The tube may be produced for example by boring out a solid material part that has previously been turned on a lathe to obtain a cylindrical form. The wall thickness of the shielding/heating tube is chosen such that the required shielding effect occurs.

There are many advantages of using a single solid shielding/heating tube but also disadvantages. The decisive disadvantage of the prior art is that the temperature profile inside the shielding/heating tube isn't possible to adjust with required accuracy.

Hence, an improved CVD-reactor design would be advantageous. In particular a CVD-reactor in which the temperature profile may be adjusted accurately inside the shielding/heating tube. It would also be preferably with a lower manufacturing cost compared to the prior art.

In the prior art, the reactor may be loaded either manually or automatically. For manually loading, normally the bottom of the process chamber function as a loading plate which carries a substrate holder on which the substrate to be coated rests. During automatic loading, normally only the substrate is handled.

A disadvantage handling the loading in accordance with the prior art is that the substrate is affected by fast temperature changes when loading and unloading at elevated temperatures.

Hence, an improved handling of the substrates would, preferably when automatically loading the reactor, be advantageous.

### SUMMARY OF THE DISCLOSURE

Accordingly, examples of the present disclosure preferably seek to mitigate, alleviate or eliminate one or more deficiencies, disadvantages or issues in the art, such as the above-identified, singly or in any combination by providing a device, system or method according to the appended patent claims for providing an improved CVD reactor, such as obtaining an adjustable temperature profile inside the shielding/heating tube and an improved handling of the substrates. According to some examples, a device, system and method for automatically loading and reloading a substrate in a reactor is disclosed. The device, system and method for automatically loading and reloading a substrate in a reactor may also be used for manual handling.

According to one aspect of the disclosure, a multi zone heater for providing a temperature profile for heating a process chamber used for depositing crystalline layers on at least one crystalline substrate is described. The multi zone heater comprises at least two heating zones made of an electrically conducting material. The multi zone heater further comprises a first zone of the at least two zones having different electrically conducting properties than a second zone of the at least two zones.

The advantages of using a multi-zone heater is that the temperature profile may be adjusted to optimize the temperature profile in the process chamber to optimize the deposition process. When the multi-zone heating tube is subjected to induction, the temperature of the different zones will vary depending on the electrical conductivity of each zone. Different electrical properties of the zones may be obtained by using, for example, different materials, different qualities of the material, different thicknesses, or a combination thereof.

In one example, the multi zone heater is tube shaped.

In another example, the multi zone heater comprises at least three heating zones. The electrical properties of at least one of the at least three heating zones is different from the other heating zones.

In another example, the multi zone heater is made from graphite.

In another example, the differences in the electrical properties are provided by using different grades of graphite.

In another example, the differences in the electrical properties are provided by using different thicknesses.

In another example, each zone of the multi zone heater is a shielding/heater tube.

According to a further aspect of the disclosure, a process chamber for depositing crystalline layers on at least one crystalline substrate is described. The process chamber comprises an inner bottom surface with a length and is configured for holding a substrate carrier. The inner bottom surface has at least two grooves arranged along the length of the inner bottom surface. The process chamber further comprises a substrate carrier having a height and is configured for holding a substrate. The substrate carrier has at least one recess arranged along an outer rim. When in use and the substrate carrier is arranged at the inner bottom surface of the process chamber, at least two elongated elements may be slid into the grooves and engage with the at least one recess on the substrate carrier, whereby the substrate carrier may be loaded or re-loaded.

Advantages with this configuration when handling the wafers are that reloading at elevated temperatures may be performed automatically as the substrate carrier is accumulating heat whereby the cooling time for the wafer carried by the substrate carrier is prolonged. This is more gentle for the wafer since it is not exposed to rapid changes in the temperature.

According to another aspect of the disclosure, a system for depositing crystalline layers on at least one crystalline substrate is disclosed. The system comprises a process chamber, such as the process chamber described above. The system further comprises a reactor housing accommodating the process chamber and consisting of an electrically non-conductive material. The system further comprises an RF heating coil surrounding the process chamber. The system also comprises a multi zone heater, such as the multi zone heater described above, having a length, the multi zone heater is disposed between the reactor housing and the process chamber. The multi zone heater has different electrical properties along the length, whereby the multi zone heater when heated by eddy currents induced by an RF field generated by the RF heating coil, and dampens the RF-field, provides a temperature profile inside the multi zone heater that varies along the length of the multi zone heater for heating the process chamber.

According to yet another aspect of the disclosure, a method for heating a process chamber used for depositing crystalline layers on at least one crystalline substrate is disclosed. The method providing a temperature profile for heating a process chamber using a multi zone heater which comprises at least two heating zones made of an electric conducting material. A first zone of the at least two zones having different electrical properties than a second zone of said at least two zones. Using at least two zones provide a temperature profile that varies along the length of the multi zone heater.

It should be emphasized that the term "comprises/comprising" when used in this specification is taken to specify the presence of stated features, integers, steps or components but does not preclude the presence or addition of one or more other features, integers, steps, components or groups thereof.

### BRIEF DESCRIPTION OF THE DRAWINGS

These and other aspects, features and advantages of which examples of the disclosure are capable of will be apparent and elucidated from the following description of embodiments of the present disclosure, reference being made to the accompanying drawings, in which:
Fig. 1 is illustrating a first exemplary 3D-cross-section through a reactor housing of a CVD reactor;
Fig. 2 is illustrating a schematic cross-section through the exemplary reactor housing of a CVD reactor in Fig. 1;
Fig. 3 is illustrating a second exemplary 3D-cross-section through a reactor housing of a CVD reactor;
Fig. 4A is illustrating an exemplary cross-section through a reactor housing of a CVD reactor; and
Fig. 4B is illustrating a detail of Fig.3.

### DESCRIPTION OF EXAMPLES

Specific examples of the disclosure will now be described with reference to the accompanying drawings. This disclosure may, however, be embodied in many different forms and should not be construed as limited to the examples set forth herein; rather, these examples are provided so that this disclosure will be thorough and complete, and will fully convey the scope of the disclosure to those skilled in the art.

While several examples of the present disclosure have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present disclosure. The scope of the disclosure is only limited by the appended patent claims.

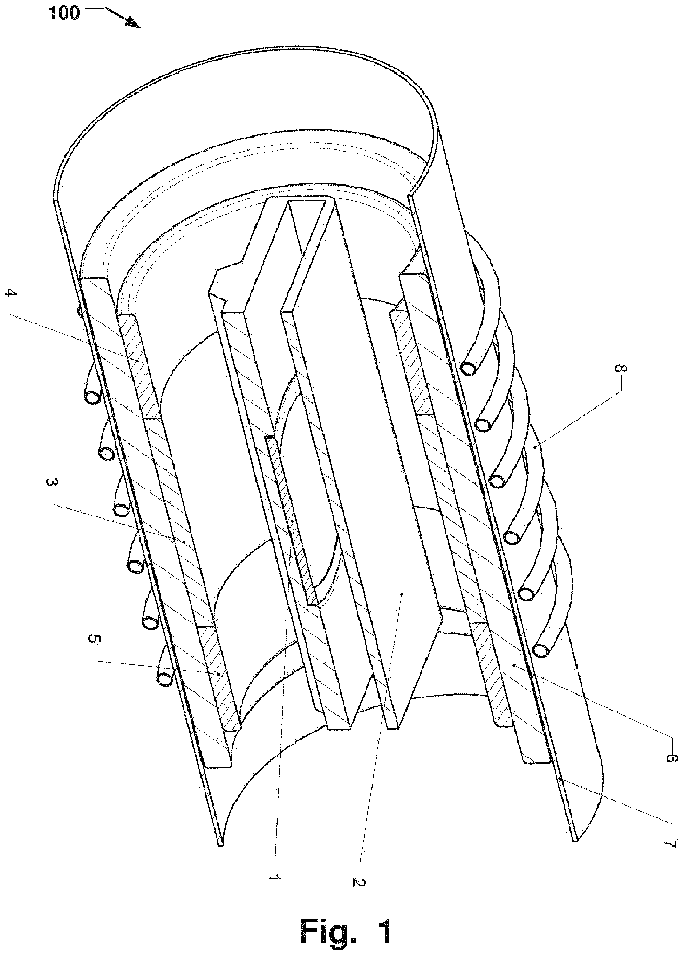

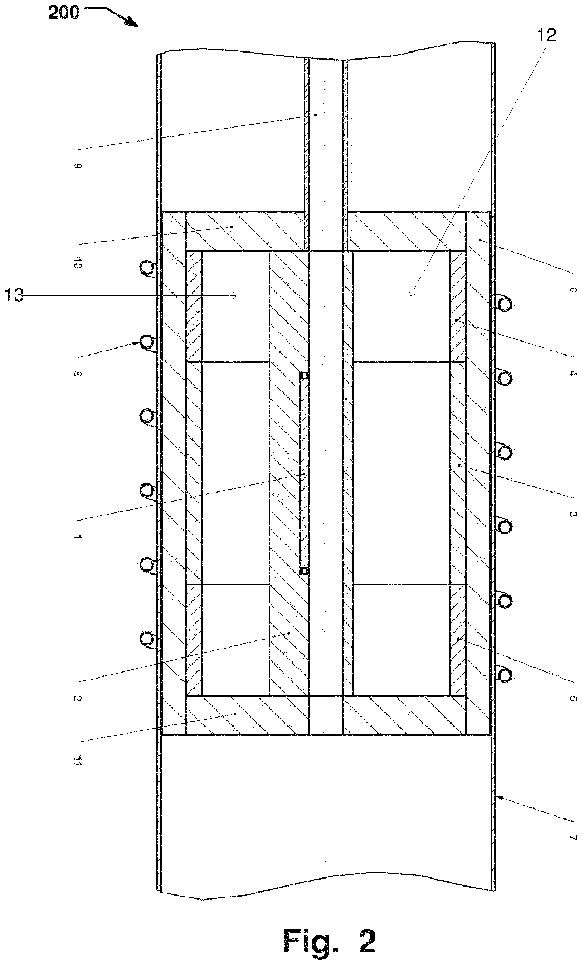

Figure 1 and figure 2 are illustrating an exemplary reactor housing 100, 200 of a CVD reactor.

The devices described in these examples are CVD reactors, which have a process chamber 2, inside which a deposition process takes place. These are CVD reactors for depositing of, for example, III-V or II-VI semiconductor layers on III-V or II-VI substrates. The reactive gases are introduced into the process chamber 2, which is heated on all sides, through a gas inlet 9. The reactive gases are preferably hydrocarbons, for example propane or ethene, and hydrides, for example silane or chlorosilanes or other gases suitable for the desired process. As a result of a pyrolytic decomposition and creation of active species inside the process chamber 2, a crystalline layer is deposited on the substrate. In addition, suitable carrier gases such as hydrogen or nitrogen are introduced into the process chamber.

The enclosure of the process chamber 2 may be formed by tube 7, made of for example quartz. The process chamber is enclosed in the region of the gas inlet 9 by an enclosure plate 10. A similar enclosure plate 11 is provided on the gas outlet side. In some examples, the enclosure plates 10 and 11 are made of an insulating material, such as graphite insulation.

An RF coil 8 is wound around the tube 7. This coil comprises a multiplicity of turns, placed axially one behind the other, so that an axial portion of the process chamber 12 lies in the region of the radio-frequency field generated by the RF coil 8.

Inside the tube 7, a multi-zone shielding/heater tube 3, 4, 5 extends over virtually the entire length of the RF coil 8. This multi-zone shielding/heater tube 3, 4, 5 is made from an electric conducting material, usually graphite. In it, the RF field of the RF coil produces eddy currents, so that the multi-zone shielding/heater tube 3, 4, 5 is heated up. The multi-zone shielding/heater tube 3, 4, 5 additionally effects a damping of the RF field in such a way that only small eddy currents are induced in the wall elements of the process chamber 2, so that the process chamber 2 as a whole is heated up substantially by thermal radiation, the radiant heat coming from the multi-zone shielding/heater tube 3, 4, 5.

The multi-zone shielding/heater tube 3, 4, 5 is made from at least two heating zones, a first zone of the at least two zones having different electrical properties than a second zone of the at least two zones.

The principle is based around indirect heating of the process chamber via a heating tube which is heated by induction. In the prior art the heating tube becomes heated evenly and thereby is the temperature profile hard to adjust.

The advantages of using a multi-zone heater is that the temperature profile may be adjusted to optimize the temperature profile in the process chamber 2 to optimize the deposition process. When the multi-zone heating tube is subjected to induction, the temperature of the different zones will vary depending on the electrical properties of each zone.

Different electrical properties of the zones may be obtained by using, for example, different materials, different qualities of the material, different thicknesses, or a combination thereof.

The multi-zone shielding/heater tube 3, 4, 5 illustrated has three heating zones, in such case all three zones may have different electrical properties, or alternatively two zones having the same electrical properties different from the electrical properties of a third zone.

A multi-zone shielding/heater tube 3, 4, 5 may be made from, for example, a single tube, or each zone could be made as separate sections that are mounted to a tube having different heating zones.

An advantage of having each zone as a separate section, that are mounted to form a tube, is that the operator may easily change between different temperature profiles by using different configurations of sections when mounting the multi-zone shielding/heater tube 3, 4, 5. This may also be less expensive to manufacture than a single solid tube.

As an example, heater ring 3 could be made of graphite having grade X, heater ring 4 could be made of graphite having grade Y, and heater ring 5 could be made of graphite having grade Z.

As a further example, heater ring 3 could be made of graphite with a thickness X, heater ring 4 could be made of graphite with a thickness Y, and heater ring 5 could be made of graphite with a thickness Z.

As a further example, heater ring 3 could be made of graphite having grade X with a thickness X', heater ring 4 could be made of graphite having grade Y with a thickness Y', and heater ring 5 could be made of graphite having grade Z with a thickness Z'.

In a further example, heater ring 4 and heater ring 5 may be made of graphite having the same grade and/or with the same thickness being different from heater ring 3.

In some examples of the reactor, an isolating layer 6 is arranged between the tube 7 and the multi-zone heater 3, 4, 5. The isolating layer may be made of graphite.

The process chamber 2 may be obtained in different ways. The chamber 2 could be made from a solid piece of material.

Alternatively, chamber 2 could be made from a top section and a bottom section. For example, a U-shaped top section rests on the periphery of the bottom section.

Alternatively, chamber 2 could be made from an upper top and a lower bottom and on the peripheral portions of the bottom there are side elements, which are positively connected to the bottom and the top of the process chamber respectively. For example, tongues on the sides engage in corresponding grooves in the top and the bottom of the process chamber 2.

As illustrated in the figures, the process chamber 2 has a rectangular form, but it could be made into other shapes. The process chamber 2 is usually made from graphite, but other materials could be used.

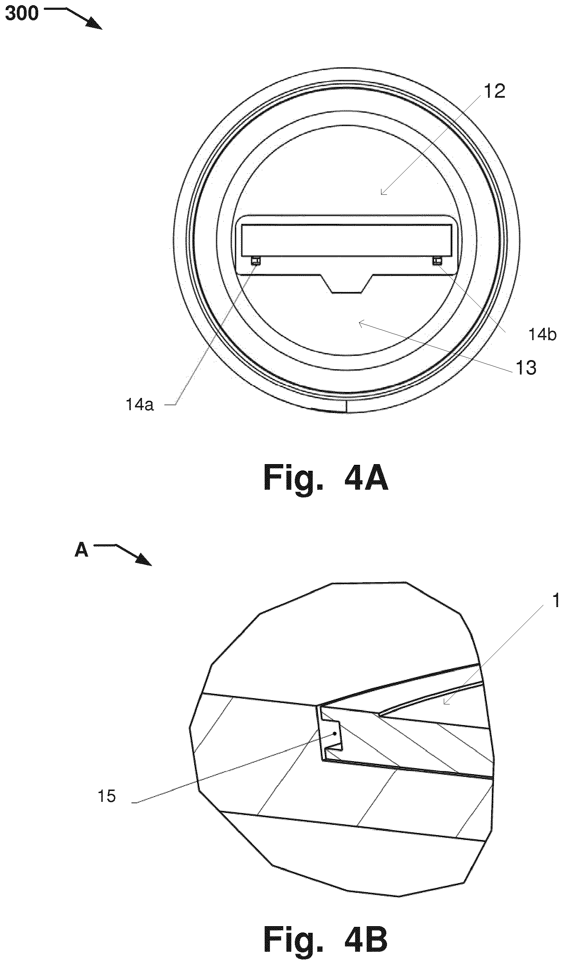

The process chamber 2 may be arranged so that at least the bottom corners are abutting at least one of the multi-zone shielding/heater tubes 3, 4, 5, as illustrated in for example, figure 4A.

In the figures there are two diametrically opposite hollows 12, 13, which are disposed underneath the bottom and above the top of the process chamber 2 respectively. These hollows 12, 13 may be used for the purpose of introducing cooling bodies in the cooling phase. These hollow spaces may also be flowed through by other types of cooling media. In the simplest case, cooling rods that are not represented in the drawings may be introduced there from the gas outlet side or the gas inlet side. These cooling rods may be water-cooled, in order to carry the heat away from the reactor quickly.

To load and reload the process chamber 2 any traditional way may be used from only handling the wafer, which is common when automatically loading the process chamber, or using a loading plate holding a substrate carrier loaded with a wafer, which is common when manually loading the process chamber.

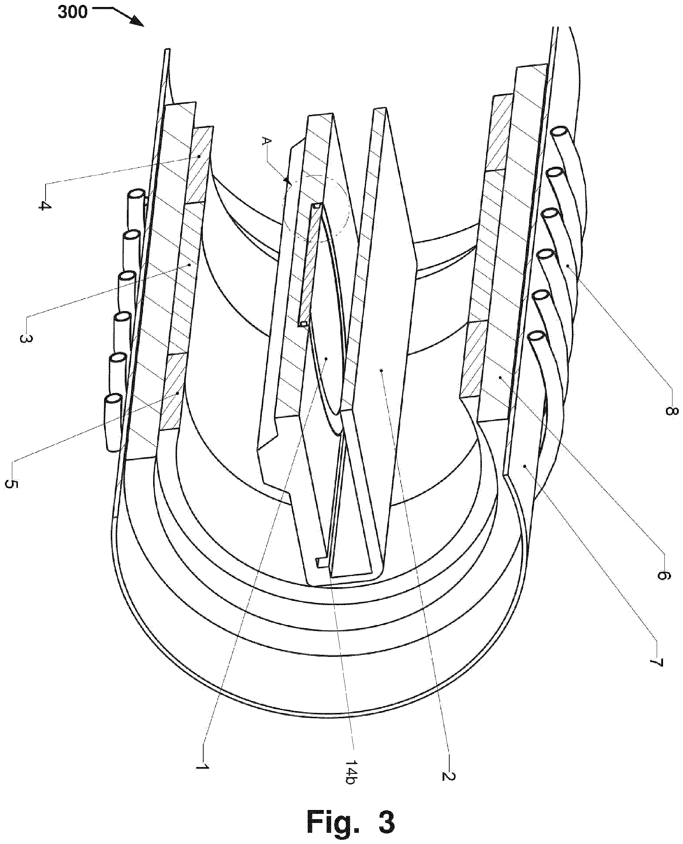

Figure 3 and figures 4A and 4B are illustrating examples of a configuration of a reactor 300 wherein an inner bottom surface of the process chamber 2 is configured for holding a substrate carrier 1. The inner bottom surface has at least two grooves 14a, 14b arranged along a length of the inner bottom surface. The substrate carrier 1 has a height and is configured for holding a substrate, such as a wafer. The substrate carrier 1 has at least one recess 15 arranged along an outer rim, see figure 4B which is an enlargement of position A in figure 3. When in use and the substrate carrier 1 is arranged at the inner bottom surface of the process chamber 2, at least two elongated elements, such as elongated rods, may be slid into the grooves 14a, 14b and engage with the at least one recess 15 whereby the substrate carrier 1 may be lifted and removed. Hence the process chamber 2 may be loaded or re-loaded without removing any further parts of the process chamber 2.

Advantages with this configuration when handling the wafers are that reloading at elevated temperatures may be performed automatically as the substrate carrier 1 is accumulating heat whereby the cooling time for the wafer carried by the substrate carrier 1 is prolonged. This is more gentle for the wafer since it is not exposed to rapid changes in the temperature.

An exemplary method for heating a process chamber used for depositing crystalline layers on at least one crystalline substrate is disclosed. The method includes providing a temperature profile for heating the process chamber. The temperature profile is obtained by using a multi zone heater which comprises at least two heating zones made of an electrically conducting material. The first zone of the at least two zones having different electrical properties than a second zone of said at least two zones.

Further disclosed herein is a method for loading or reloading a substrate in a reactor. The method may be used both for automatic or manual loading or reloading. The method comprises a process chamber with an inner bottom surface that has a length and is configured for holding a substrate carrier, the inner bottom surface with at least two grooves arranged along the length of the inner bottom surface, a substrate carrier having a height and is configured for holding a substrate, the substrate carrier with a at least one recess arranged along an outer rim.

Sliding to elongated elements, such as elongated rods, into the at least two grooves.

Engaging the elongated elements with the at least one recess of the substrate carrier whereby the substrate carrier may be loaded and/or re-loaded with a substrate.

While several examples of the present disclosure have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present disclosure. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings of the present disclosure is/are used. Also, different method steps than those described above, performing the method by hardware, may be provided within the scope of the disclosure. The different features and steps of the disclosure may be combined in other combinations than those described. The scope of the invention is only limited by the appended patent claims.

## Claims

1. A multi zone heater for providing a temperature profile for heating a process chamber (2) used for depositing crystalline layers on at least one crystalline substrate, the multi zone heater comprises:
at least two heating zones (3, 4, 5) made of an electric conducting material, and a first zone of the at least two zones (3, 4, 5) having different electrical properties than a second zone of the at least two zones (3, 4, 5); and
whereby the multi zone heater has different electrical properties along a length.

2. The device according to claim 1, wherein the multi zone heater is tube shaped.

3. The device according to any of claims 1 or 2,
wherein the multi zone heater comprises at least three heating zones (3, 4, 5), wherein the electrical properties of at least one of the at least three heating zones is different from the other heating zones.

4. The device of any of claims 1 to 3, wherein multi zone heater is made from graphite.

5. The device of claim 4, wherein the differences in the electrical properties are provided by using different grades of graphite.

6. The device of any of claims 1 to 5, wherein the differences in the electrical properties are provided by using different thicknesses.

7. The device of any of claims 1 to 6, wherein each zone (3, 4, 5) of the multi zone heater is a shielding/heater tube.

8. A process chamber (2) for depositing crystalline layers on at least one crystalline substrate, the process chamber (2) comprises:
an inner bottom surface having a length and is configured for holding a substrate carrier (1), the inner bottom surface having at least two grooves (14a, 14b) arranged along the length of the inner bottom surface;
a substrate carrier (1) having a height and is configured for holding a substrate, the substrate carrier (1) having a at least one recess (15) arranged along an outer rim; when in use and the substrate carrier (1) is arranged at the inner bottom surface, at least two elongated elements can be slid into the grooves (14a, 14b) and engage with the at least one recess (15) whereby the substrate carrier (1) is loaded or re-loaded.

9. A system for depositing crystalline layers on at least one crystalline substrate, comprising:
a process chamber (2), such as the process chamber according to claim 8;
a reactor housing (100, 200), accommodating the process chamber (2) and consisting of an electrically non-conductive material;
an RF heating coil (8) surrounding the process chamber (2); and
a multi zone heater (3, 4, 5), such as the multi zone heater of any of claim 1 to 7, having a length, the multi zone heater (3, 4, 5) is disposed between the reactor housing (100, 200) and the process chamber (2), the multi zone heater (3, 4, 5) has different electrical properties along the length, whereby the multi zone heater (3, 4, 5) when heated by eddy currents induced by an RF field generated by the RF heating coil (8), absorbing the RF-field, provides a temperature profile inside the multi zone heater (3, 4, 5) that varies along the length of the multi zone heater (3, 4, 5) for heating the process chamber (2).

10. A method for heating a process chamber (2) used for depositing crystalline layers on at least one crystalline substrate, comprising:
providing a temperature profile for heating said process chamber (2) using a multi zone heater which comprises at least two heating zones (3, 4, 5) made of an electrically conducting material, and a first zone of the at least two zones (3, 4, 5) having different electrical properties than a second zone of said at least two zones (3, 4, 5); whereby the multi zone heater has different electrical properties along a length.
